# FASCICULE DE BREVET EUROPEEN

(11) **EP 2 909 906 B1**
(45) Date de publication et mention de la délivrance du brevet: **13.06.2018**
(21) Numéro de dépôt: 13779839.3
(22) Date de dépôt: 21.10.2013
(51) Int. Cl.: H02G 5/06

(54) **APPAREILLAGE ÉLECTRIQUE COMPRENANT UN SUPPORT D'UN CONDUCTEUR ENTRE DEUX PORTIONS D'ENVELOPPE**
ELEKTRISCHE VORRICHTUNG MIT LEITERTRÄGER ZWISCHEN ZWEI KAPSELUNGSTEILEN
ELECTRICAL DEVICE COMPRISING A CONDUCTOR SUPPORT BETWEEN TWO PARTS OF A CASING

(30) Priorité: 22.10.2012 FR 1260027
(43) Date de publication de la demande: 26.08.2015
(73) Titulaire: General Electric Technology GmbH, 5400 Baden (CH)
(72) Inventeur: CARON, Adrien, 73000 Barberaz (FR); LARUELLE, Elodie, 73100 Aix les Bains (FR); GIUSTI, Alexandre, 73100 Aix les Bains (FR); BERNARD, Mathieu, 73100 Aix les Bains (FR); MÜLLER, Benjamin, 5600 Lenzburg (CH); TREIER, Lukas, 5043 Holziken (CH)
(74) Mandataire: Fischer, Michael Maria
(86) Numéro de dépôt international: PCT/EP2013/071991
(87) Numéro de publication internationale: WO 2014/064056

(56) Documents cités:
- US-A- 3 372 226
- US-A1- 2002 153 352
- US-A1- 2002 158 721

## Description

Le sujet de l'invention présente est un appareillage électrique comprenant un support d'un conducteur entre deux portions d'enveloppe.

Un tel appareillage électrique peut appartenir à un réseau à haute ou moyenne tension, dans lequel les conducteurs sont entourés par des enveloppes dont une fonction importante est de permettre le maintien d'une atmosphère particulière diélectrique, traditionnellement de l'hexafluorure de soufre (SF₆), quoique d'autres gaz soient maintenant employés avec la même intention.

Les conducteurs sont maintenus au centre des enveloppes par des supports en forme de disque ou de cône, dont le bord extérieur s'appuie sur la paroi de l'enveloppe. Les enveloppes sont en pratique constituées de portions assemblées entre elles et très souvent de forme cylindrique, dans l'axe desquelles s'étendent des portions linéaires des conducteurs. Les supports isolants peuvent alors être placés à la jonction de deux portions assemblées de l'enveloppe.

Dans un grand nombre de conceptions, illustrées notamment par le document EP-A-2 086 081, le support isolant s'étend en séparant complètement l'une de l'autre les brides d'assemblage des portions d'enveloppe. Des douilles métalliques sont disposées autour des boulons d'assemblage des brides, de manière à servir d'espaceurs et éviter un écrasement du support, généralement de faible résistance mécanique, par le serrage des boulons. La nécessité d'ajouter ces douilles complique et enchérit l'assemblage ; l'étanchéité à l'égard de l'extérieur doit être assurée des deux côtés du support par des joints serrés contre les brides respectives, avec le même inconvénient de complication ; l'exposition du bord du support à l'extérieur de l'appareillage est plutôt défavorable, puisqu'il peut être exposé à divers dommages ; et la discontinuité des portions d'enveloppe empêche les courants électriques de retour de bien circuler à travers elles. Ces deux derniers inconvénients peuvent être éliminés en ajoutant des manchettes autour des brides, qui contribuent donc à les relier tout en couvrant le bord du support, mais l'appareillage en est encore compliqué.

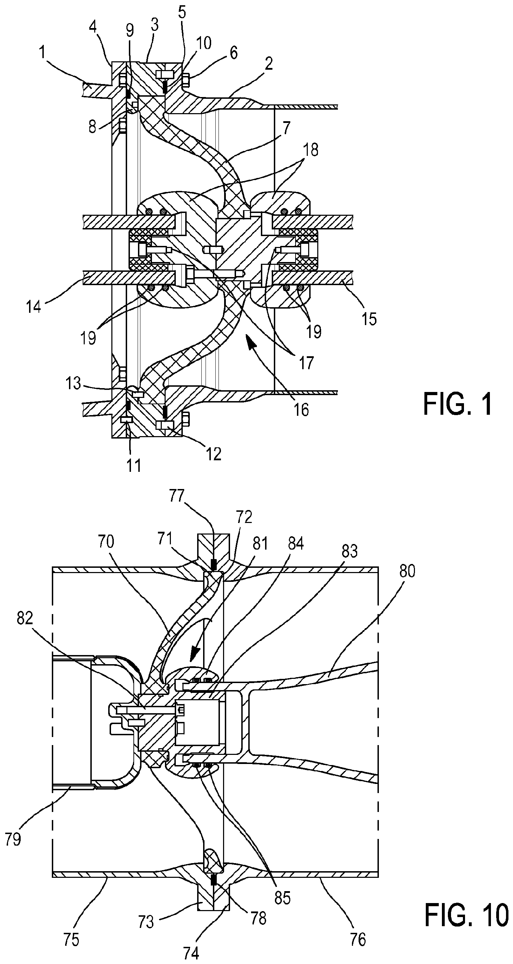

Dans un autre genre de conception, dont une réalisation est représentée à la figure 1, les portions d'enveloppe 1 et 2, en alignement, sont séparées par une pièce appelée contre-bride 3 qui s'étend entre les brides 4 et 5 d'assemblage. Des boulons 6 d'assemblage de l'appareillage traversant la contre-bride 3 l'enserrent entre les brides 4 et 5. Le support 7 isolant est entouré par une portion principale de la contre-bride 3, et retenu en direction axiale de l'appareillage entre une des brides 5 et une lèvre 8 radialement interne de la contre-bride 3. Deux joints 9 et 10 d'étanchéité sont comprimés entre la contre-bride 3 et les brides 4 et 5 respectives, afin d'établir l'étanchéité à l'égard de l'extérieur et d'empêcher ainsi des fuites du gaz diélectrique. Des pions 11, 12 et 13 sont disposés entre la contre-bride 3, et, respectivement, les brides 1, 2 et le bord du support 7, de manière à maintenir toutes ces pièces à une position angulaire invariable. Dans cette réalisation particulière, le conducteur global est formé de deux conducteurs 14 et 15 linéaires et autonomes, respectivement contenus par les portions 1 et 2, et d'un raccordement 16 assujetti au support 7, le traversant à son centre, et comprenant de chaque côté un embout 17, autour duquel les extrémités des conducteurs 14 et 15 sont enfoncés, un pare-effluve 18 entourant l'embout 17 et lesdits conducteurs 14 et 15 quand elles sont en place, et des ressorts de contact 19 saillant dans le bord interne des pare-effluve 18 cylindriques afin de retenir les extrémités des conducteurs 14 et 15 et de favoriser la conduction électrique.

La contre-bride 3 donne une meilleure cohésion à l'assemblage et permet notamment de bien maintenir le support 7 malgré les sollicitations mécaniques, thermiques et électromagnétiques qu'il subit, tout en le protégeant de l'extérieur ; les inconvénients de cette conception sont toutefois encore une certaine complication de l'assemblage, à cause de l'addition de la contre-bride 3 et de la présence de deux joints d'étanchéité 9 et 10 sur les faces planes opposées de la contre-bride. D'autres inconvénients de la réalisation de la figure 1 sont que le raccordement des portions du conducteur est lui aussi compliqué, avec la même conséquence d'un coût élevé de l'appareillage dû au nombre important de pièces utilisées, et aussi de pertes électriques à cause des défauts de contact aux deux raccordements du conducteur.

D'autres appareillages sont le sujet des documents US-2002/158 721-A, US 2002/153 352-A et US 3 372 226-A, où le support isolant est directement retenu dans les logements formés par les deux brides de raccordement, sans qu'aucune contre-bride soit utilisée.

Cette conception permet de beaucoup simplifier l'assemblage, en supprimant la contre-bride ou les douilles d'espacement. Le support isolant reste bien protégé de l'extérieur et bien maintenu par les brides. Un joint d'étanchéité unique suffit, ce qui contribue encore à simplifier l'assemblage, tout en diminuant les risques de communication de gaz entre l'intérieur et l'extérieur de l'enveloppe, puisqu'une seule interface subsiste le long de l'enveloppe. Une grande latitude de conception de l'appareillage existe grâce à la séparation entre les portions affectées à l'étanchéité et les portions affectées à la tenue du support isolant sur les brides, quand le joint est complètement séparé de la portion périphérique du support isolant.

Il est proposé ici un appareillage électrique comprenant, comme précédemment, deux portions d'une enveloppe d'au moins un conducteur électrique, un support isolant du conducteur que traverse le conducteur et qui s'appuie sur l'enveloppe, les portions de l'enveloppe étant jointes par des brides et le support isolant comprenant une portion périphérique logée entre les brides ; les brides possèdent des faces en contact et un joint d'étanchéité est comprimé entre lesdites faces en entourant la portion périphérique. Les brides comprennent des faces planes et parallèles entre lesquelles la portion périphérique est logée et des faces circulaires en prolongement qui entourent la portion périphérique. Et l'appareillage est original en ce que le support comporte une collerette sur un bord extérieur et une collerette sur une face essentiellement plane, la portion périphérique est reçue dans un logement des brides avec un jeu, sauf aux collerettes, qui sont respectivement en appui sur la face circulaire d'une des brides et sur la face plane d'une des brides.

Les collerettes saillantes, en appui sur au moins une des faces planes et parallèles et au moins une des faces circulaires des brides, font reposer le support sur la face ou les faces en question avec une épaisseur réduite. Si le montage ou les dilatations thermiques créent une compression du support, elle est absorbée par une déformation des collerettes, sans créer de contraintes importantes dans la portion principale du support. De telles collerettes peuvent donc s'étendre sur les faces latérales du support ou sa face extérieure, de manière à aider à une butée soit en direction axiale, soit en direction radiale de l'appareillage.

Les dilatations thermiques différentielles auxquelles le support est soumis ne produisent pas ainsi de contraintes mécaniques importantes sur lui.

Les collerettes saillantes peuvent être entaillées d'un canal ou de canaux de communication de gaz, afin qu'une atmosphère diélectrique de même composition s'étende dans tout l'appareillage et notamment tous les interstices entre la portion périphérique du support et les brides.

L'invention est bien compatible avec des supports de forme simplifiée, ayant une épaisseur essentiellement uniforme à une portion principale s'étendant de la portion périphérique vers une région centrale du support, la portion périphérique ayant une épaisseur au moins égale à la portion principale. Dans cette réalisation particulière, le support peut notamment être un disque ayant une épaisseur essentiellement constante sur toute son étendue ; une épaisseur plus forte à la portion périphérique peut toutefois être envisagée pour renforcer le support à cette portion périphérique où il est encastré et peut donc être soumis à des charges plus importantes.

L'appareillage de l'invention peut favorablement être employé avec un réseau triphasé, comprenant trois conducteurs contenus dans la même enveloppe et s'étendant parallèlement entre eux, à travers le support isolant ; ce dernier aura alors souvent la forme d'un disque.

Les brides et les portions d'enveloppe seront, en général, unies entre elles par un cercle de boulons, ainsi qu'il est usuel, mais sans qu'il faille utiliser des douilles d'espacement ou d'autres pièces, puisque les brides sont directement serrées entre elles ; il sera toutefois possible d'ajouter des moyens de fixation du support isolant à une des portions d'enveloppe, afin d'augmenter la cohésion de l'appareillage, aussi bien avant de l'assembler que quand il est assemblé. De tels moyens de fixation peuvent comprendre des vis engagées à travers la portion périphérique et dans des taraudages établis sous la face plane d'une des brides. Un serrage modéré peut être appliqué à ces vis au lieu du serrage fort utilisé pour assembler les brides entre elles. Le support peut alors comprendre des douilles métalliques dans lesquelles les vis sont engagées, avec des têtes de vis pesant sur les douilles, de manière que l'effort de serrage s'exerce sur ces douilles, mais pas sur le support isolant lui-même.

On a vu qu'un des avantages de l'invention était de permettre d'économiser un joint d'étanchéité par rapport aux conceptions antérieures. Il est malgré cela possible d'ajouter un second joint d'étanchéité, comprimé entre la portion périphérique du support isolant et une des faces planes des brides, afin de séparer les atmosphères des deux compartiments de l'enveloppe séparés par le support.

On va maintenant passer à une description plus détaillée de l'invention, qui sera donnée au moyen de quelques réalisations purement illustratives et à l'aide des figures annexée :
- la figure 1, déjà décrite, représente un appareillage électrique comprenant un raccordement traditionnel de brides et de conducteurs ;
- les figures 2 à 5 illustrent une réalisation de l'invention, la figure 2 illustrant le support isolé ; la figure 3, un détail de ce support ; la figure 4 et la figure 5, deux vues de la portion périphérique du support logée entre les brides ;
- les figures 6 à 9 illustrent une autre réalisation d'appareillage (qui n'est pas couverte par l'invention), la figure 6 étant une vue générale de l'appareillage en coupe ; la figure 7, une vue en coupe transversale ; la figure 8, un détail de la figure 6 ; et la figure 9, un détail de la portion périphérique du support isolant et de ses alentours, à une autre position angulaire qu'à la figure 8 ;
- et les figures 10, 11 et 12 illustrent une autre réalisation d'appareillage (qui n'est pas couverte par l'invention).

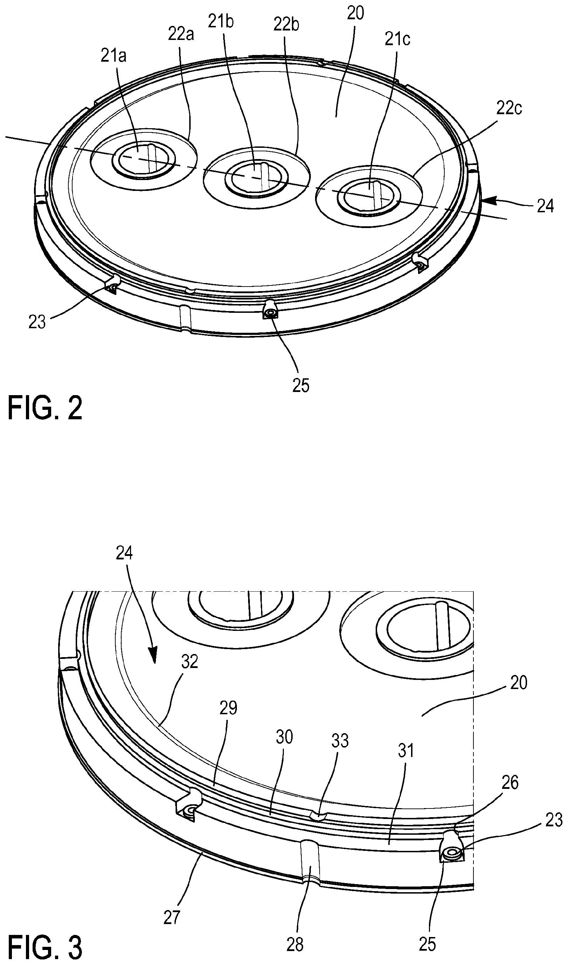

On passe au commentaire des figures 2 à 5. Cette réalisation du support isolant, maintenant 20, est en forme de disque et comporte trois perçages 21a, 21b et 21c, alignés sur un diamètre pour le passage de trois conducteurs d'un réseau triphasé. Le support isolant 20 peut être construit conformément aux règles données dans le document EP-A-2 086 081 mentionné plus haut et posséder notamment deux faces essentiellement planes et une épaisseur à peu près uniforme sur toute son étendue, des cavités peu profondes 22a, 22b et 22c étant toutefois opérées autour des perçages 21a, 21b et 21c.

D'autres perçages, tous référencés par 23, s'étendent à la portion périphérique 24 du support 20 ; ils sont au nombre de huit et répartis uniformément en direction angulaire ; ils contiennent chacun une douille 25. Un évidement 26 est opéré devant eux sur une des faces planes du support.

Le bord extérieur du support 20 comprend une collerette 27 de faible hauteur et faible épaisseur, et au moins un canal 28 entaillant la face extérieure de la portion périphérique 24 et traversant cette collerette 27. Les faces essentiellement planes du support 20 comportent encore des irrégularités de forme à la portion périphérique 24 et près d'elle, à savoir une cavité annulaire 32, puis une collerette 29, une première dénivellation 30 et une seconde dénivellation 31, en allant vers l'extérieur radialement. La collerette 29 est entaillée elle aussi par un canal 33 s'étendant en direction radiale. La cavité annulaire 32 est établie pour les raisons données dans le document cité plus haut EP-A-2 086 051. Nous abordons maintenant la description de l'appareillage électrique lui-même, et plus précisément de son assemblage avec l'enveloppe.

Les portions d'enveloppe 34 et 35, en alignement, comportent des brides 36 et 37 possédant des faces de contact jointes à une interface 38 entourant le support 20 isolant. Les brides 36 et 37 délimitent entouré par l'interface 38, un logement 39 de réception de la partie périphérique 24 avec, en général, un petit jeu ; les collerettes 27 et 29 sont toutefois en appui respectivement sur une des faces circulaires et en alignement des brides 36 et 37, et sur des faces planes et parallèles des mêmes, qui délimitent le logement 39. Un joint d'étanchéité 40 est présent dans la première dénivellation 30 d'une des faces du support 20, afin d'établir une étanchéité entre les deux compartiments de l'enveloppe séparés par le support 20 quand elle est nécessaire. Les canaux 28 et 33 permettent toutefois à l'atmosphère diélectrique des deux compartiments de parvenir jusqu'aux deux côtés opposés du joint 40 et d'occuper ainsi tous les interstices de l'enveloppe.

Un joint d'étanchéité 41 principal est établi dans des gorges creusées dans les faces en contact des brides 36 et 37 afin d'éviter la communication de gaz entre l'intérieur et l'extérieur de l'appareillage électrique. Par rapport à la conception de la figure 1, il existe un trajet unique de fuites potentielles vers l'extérieur, à l'interface 38, que le joint 40 unique suffit à garder.

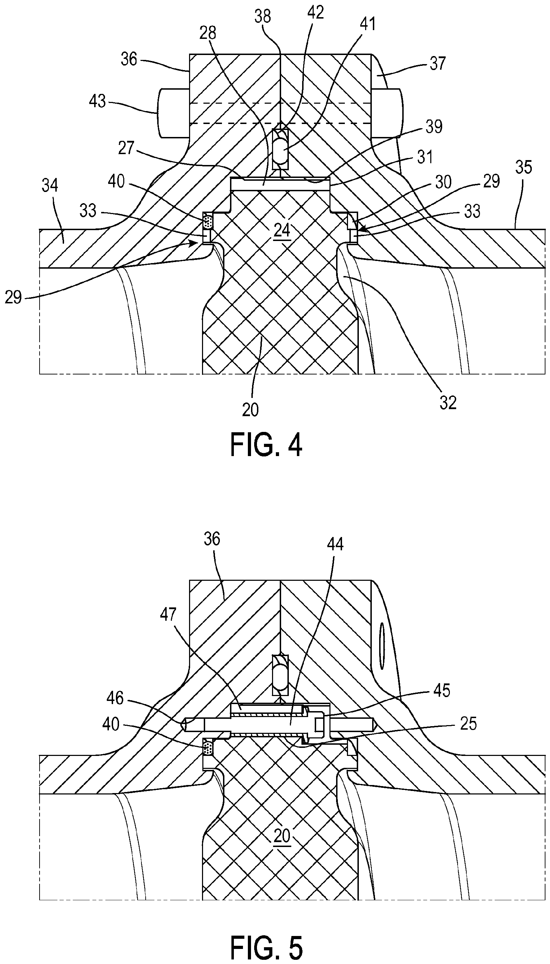

Les boulons 43 de serrage des brides 36 et 37 sont répartis autour du joint 41. La figure 5 montre que des vis 44 sont disposées dans les perçages 23 et les douilles 25 ; leur tête 45 s'appuie sur les extrémités de ces douilles 25, qui reposent sur des faces planes d'une des brides 36 délimitant le logement 39 ; et les vis 44 pénètrent dans des taraudages 46 établis sous cette face plane 47. En exerçant un serrage modéré sur les vis 44, on crée un blocage du support 20 sur la bride 36, ce qui facilite l'assemblage de l'appareillage et augmente la cohésion ensuite. Le joint d'étanchéité 40 est de plus retenu dès le début, puisqu'il est du côté des taraudages 46.

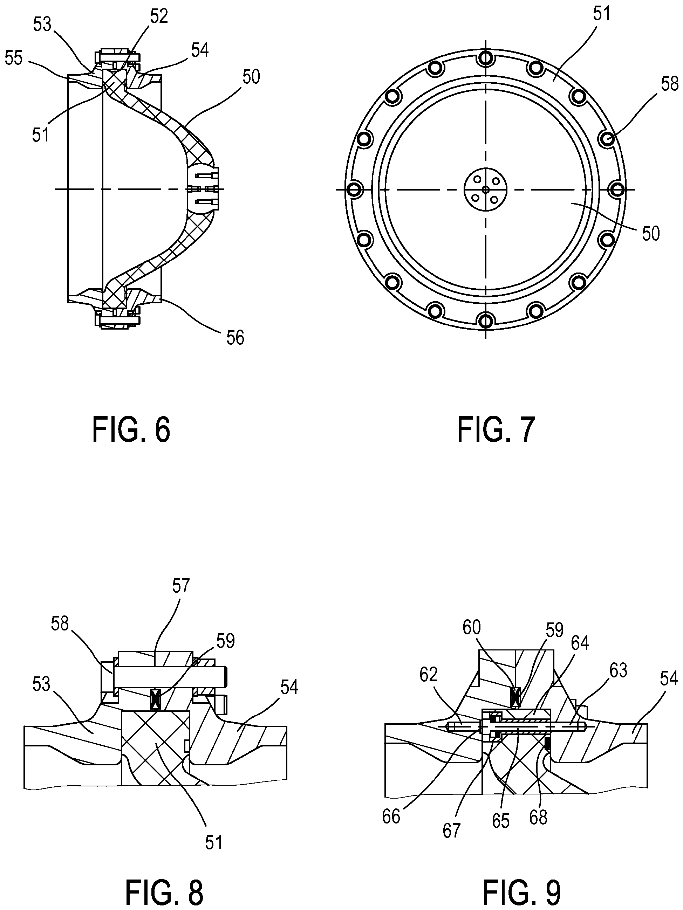

La description d'une deuxième réalisation d'appareillage (qui n'est pas couverte par l'invention) est maintenant abordée au moyen des figures 6 à 9. Dans cette réalisation, le support 50 isolant a la forme d'un cône. Sa portion périphérique 51 est encore engagée dans un logement 52, établi entre deux brides 53 et 54 de deux portions d'enveloppe 55 et 56 en prolongement. Les brides 53 et 54 comprennent encore des faces en contact à une interface 57, et elles sont serrées par des boulons 58 répartis en cercle. Un joint d'étanchéité 59 est logé dans une gorge 60, établie sur les faces en contact ; il est entouré par le cercle de boulons 58, mais entoure la portion périphérique 51 du support 50. Le joint 59 peut être un joint à lobes (à section en papillon) ou composé de deux joints toriques. Un seul trajet de fuites potentielles existe ici aussi, ce qui simplifie l'assemblage même si plusieurs joints sont utilisés, ce qui n'est pas indispensable.

La figure 7 montre que la portion périphérique 51 peut être échancrée à l'endroit des boulons 58 et saillante ailleurs, de manière à envelopper partiellement les boulons 58.

Les brides 53 et 54 sont munies de taraudages 62 et 63, qui s'étendent sous les faces planes en regard délimitant le logement 52. La portion périphérique 51 est munie de perçages dans lesquels des douilles 64 sont installées. Des vis 65 assurent le maintien du support 50 sur une des brides, ici 54, en étant engagées dans les taraudages correspondants (ici 63). Les têtes 66 des vis appuient sur les douilles 64 par l'intermédiaire de rondelles 67 à arc-boutement qui empêchent le desserrage. Une gorge est creusée dans la face de la portion périphérique 51, en appui sur la bride 54, pour recevoir un second joint d'étanchéité 68, torique, qui établit encore l'étanchéité entre les compartiments de l'enveloppe séparés par le support 50. Dans ce mode de réalisation, le support 50 peut être maintenu sur l'une ou l'autre des brides 53 et 54 à condition de le retourner.

Un autre appareillage (qui n'est pas couvert par l'invention) sera maintenant décrit en liaison aux figures 10 à 12. On retrouve un support 70 isolant, de forme conique, ayant une portion périphérique 61 plus épaisse, retenue dans un logement 72 annulaire, délimité par des brides 73 et 74 de deux portions 75 et 76 d'enveloppe, et qui présente encore une interface 77 de contact, un joint 78 établissant encore l'étanchéité à l'interface 77 et entourant la portion périphérique 71.

La description porte maintenant sur les raccordements électriques. Chacun des compartiments délimités par les portions d'enveloppe 75 et 76 contient un conducteur 79 ou 81 linéaire, dont la jonction est faite par un raccordement 81 également conducteur assujetti au support 70. Dans cette réalisation, un des conducteurs 79 est fixé par des vis 82 au raccordement 81, alors que l'autre conducteur 80 est engagé autour d'un embout 83 du raccordement 81, de façon librement détachable, la liaison étant complétée par un pare-effluve 84, entourant le conducteur 80 muni de ressorts de contact 85 établis dans la concavité du pare-effluve 84 qui établissent un serrage et favorisent la conduction à travers le raccordement 81 quand le conducteur 80 est enfoncé dans ladite concavité.

Ce mode de réalisation est original par rapport à celui de la figure 1 en ce que le raccordement 81 et le support 70 sont assujettis au conducteur 79 et donc maintenus plus fermement. On doit aussi souligner que le support 70 est retenu même quand les brides 73 et 74 sont disjointes, que le nombre de pièces de raccordement électrique est réduit et que la liaison par fixation s'accompagne de pertes électriques moins importantes que la liaison par enfilage et maintien par des ressorts de contact 85 : le dispositif est donc à la fois moins coûteux et meilleur transmetteur.

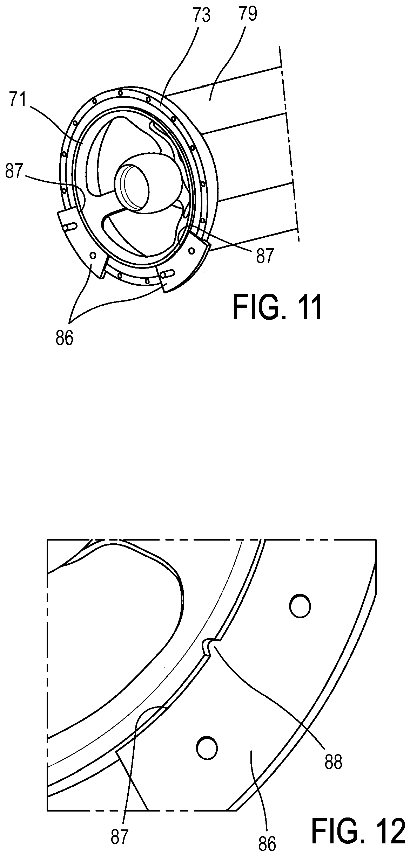

Il est possible de disposer d'un outillage pour faciliter le transport et l'assemblage du dispositif. La figure 11 montre qu'il consiste en des collerettes 86, à boulonner à la bride 73 du conducteur 79 tant qu'elle n'est pas assemblée à l'autre bride 74. Les collerettes 86 comportent un bord 87 de soutien de la portion périphérique 71 du support 70, et qui peut être muni, d'après la figure 12, d'un ergot 88 engagé dans une encoche correspondante de la portion périphérique 71 et interdit donc sa rotation.

Il est manifeste que d'autres modes de réalisation de l'invention sont possibles.

## Revendications

1. Appareillage électrique comprenant deux portions (34, 35) d'une enveloppe d'au moins un conducteur électrique, un support (20) isolant du conducteur que traverse le conducteur et qui s'appuie sur l'enveloppe, les portions de l'enveloppe étant jointes par des brides (36, 37) et le support isolant comprenant une portion périphérique (24) logée entre les brides, les brides possédant des faces en contact (38); un joint d'étanchéité (41) étant comprimé entre lesdites faces en entourant la portion périphérique (24); les brides (36, 37) comprenant des faces planes et parallèles entre lesquelles la portion périphérique est logée et des faces circulaires en prolongement entourant la portion périphérique ;
**caractérisé en ce que** le support (20) comporte une collerette (27) sur un bord extérieur et une collerette (29) sur une face essentiellement plane, la portion périphérique (24) est reçue dans un logement (39) des brides avec un jeu, sauf aux collerettes, qui sont respectivement en appui sur la face circulaire d'une des brides (36, 37) et la face plane d'une des brides (36, 37).

2. Appareillage électrique selon la revendication 1, **caractérisé en ce que** les collerettes sont entaillées d'au moins un canal (28, 33) de communication de gaz.

3. Appareillage électrique selon la revendication 1 ou 2, **caractérisé en ce que** le support a une épaisseur essentiellement uniforme à une portion principale s'étendant de la portion périphérique vers une région centrale du support, et la portion périphérique a une épaisseur au moins égale à la portion principale.

4. Appareillage électrique selon la revendication 3, **caractérisé en ce que** le support (20) est un disque ayant une épaisseur essentiellement constante.

5. Appareillage électrique selon la revendication 4, **caractérisé en ce qu'**il est triphasé et comprend trois conducteurs électriques s'étendant parallèlement.

6. Appareillage électrique selon la revendication 3, **caractérisé en ce qu'**il comprend des moyens de fixation du support à une des portions d'enveloppe.

7. Appareillage électrique selon la revendication 6, **caractérisé en ce que** les moyens de fixation comprenant des vis (44) engagées à travers la portion périphérique (24) et dans des taraudages (46) établis sous la face plane de la bride de ladite une des portions d'enveloppe.

8. Appareillage électrique selon la revendication 7, **caractérisé en ce que** le support comprend des douilles (25) métalliques dans lesquelles les vis sont engagées, avec des têtes de vis pressant sur les douilles.

9. Appareillage électrique selon la revendication 1, **caractérisé en ce qu'**il comprend un autre joint d'étanchéité (40), comprimé entre la portion périphérique et une des faces planes des brides.

## Patentansprüche

1. Elektrische Vorrichtung mit zwei Abschnitten (34, 35) eines Mantels zumindest eines elektrischen Leiters, einem isolierenden Träger (20) des Leiters, den der Leiter durchquert und der sich auf dem Mantel abstützt, wobei die Abschnitte des Mantels durch Flansche (36, 37) miteinander verbunden sind und der isolierende Träger einen Umfangsabschnitt (24) umfasst, der zwischen den Flanschen angeordnet ist, wobei die Flansche Kontaktflächen (38) aufweisen; einer Dichtung (41), die zwischen diesen Flächen zusammengedrückt wird und dabei den Umfangsabschnitt (24) einschließen; wobei die Flansche (36, 37) ebene und parallele Flächen umfassen, zwischen denen der Umfangsabschnitt angeordnet ist, und in der Verlängerung kreisförmige Flächen umfassen, die den Umfangsabschnitt einschließen;
**dadurch gekennzeichnet, dass** der Träger (20) einen Bund (27) am äußeren Rand und einen Bund (29) an einer im Wesentlichen ebenen Fläche aufweist und dass der Umfangsabschnitt (24) in einer Aufnahme (39) der Flansche mit einem Spiel aufgenommen ist, außer an den Bunden, die sich jeweils an der kreisförmigen Fläche eines der Flansche (36, 37) und der ebenen Fläche der Flansche (36, 37) abstützen.

2. Elektrische Vorrichtung nach Anspruch 1, **dadurch gekennzeichnet, dass** die Bunde mit zumindest einem Gasverbindungskanal (28, 33) eingekehlt sind.

3. Elektrische Vorrichtung nach Anspruch 1 oder 2, **dadurch gekennzeichnet, dass** der Träger in einem Hauptabschnitt, der sich vom Umfangsabschnitt zum zentralen Bereich des Trägers erstreckt, eine im Wesentlichen gleichmäßige Stärke aufweist und dass der Umfangsabschnitt eine Stärke aufweist, die mindestens derjenigen des Hauptabschnitts entspricht.

4. Elektrische Vorrichtung nach Anspruch 3, **dadurch gekennzeichnet, dass** der Träger (20) eine Scheibe mit einer im Wesentlichen konstanten Stärke ist.

5. Elektrische Vorrichtung nach Anspruch 4, **dadurch gekennzeichnet, dass** sie dreiphasig ist und drei elektrische Leiter umfasst, die parallel verlaufen.

6. Elektrische Vorrichtung nach Anspruch 3, **dadurch gekennzeichnet, dass** sie Mittel zur Befestigung des Trägers an einem der Mantelabschnitte umfasst.

7. Elektrische Vorrichtung nach Anspruch 6, **dadurch gekennzeichnet, dass** die Befestigungsmittel Schrauben (44) umfassen, die durch den Umfangsabschnitt (24) und in Gewindebohrungen (46) im Eingriff stehen, die unter der ebenen Fläche des Flansches des Umfangsabschnitts ausgeführt sind.

8. Elektrische Vorrichtung nach Anspruch 7, **dadurch gekennzeichnet, dass** der Träger Metallhülsen (25) umfasst, in denen die Schrauben im Eingriff sind, wobei die Schraubenköpfe auf die Hülsen drücken.

9. Elektrische Vorrichtung nach Anspruch 1, **dadurch gekennzeichnet, dass** sie eine weitere Dichtung (40) umfasst, die zwischen dem Umfangsabschnitt und einer der ebenen Flächen der Flansche zusammengedrückt wird.

## Claims

1. Electrical device comprising two portions (34, 35) of a case of at least one electrical conductor, a support (20) insulating the conductor, which crosses the conductor and which is supported by the case, the portions of the case being secured by flanges (36, 37), and the insulating support comprising a peripheral portion (24) housed between the flanges, the flanges having contacting faces (38); a seal (41) being compressed between said faces surrounding the peripheral portion (24); the flanges (36, 37) comprising flat and parallel faces between which the peripheral portion is housed and extended circular faces surrounding the peripheral portion;
**characterised in that** the support (20) comprises a collar (27) on an outer edge and a collar (29) on a mainly flat face, the peripheral portion (24) is received in a housing (39) of the flanges with a gap, except for the collars, which are respectively supported on the circular face of one of the flanges (36, 37) and the flat face of one of the flanges (36, 37).

2. Electrical device according to claim 1, **characterised in that** the collars are notched with at least one gas communication channel (28, 33).

3. Electrical device according to claim 1 or 2, **characterised in that** the support has a mainly consistent thickness with a main portion extending from the peripheral portion to a central region of the support, and the peripheral portion has a thickness at least equal to the main portion.

4. Electrical device according to claim 3, **characterised in that** the support (20) is a disc having a mainly constant thickness.

5. Electrical device according to claim 4, **characterised in that** it is three-phase and comprises three electrical conductors extending parallel.

6. Electrical device according to claim 3, **characterised in that** it comprises means for securing the support to one of the case portions.

7. Electrical device according to claim 6, **characterised in that** the securing means comprise screws (44) inserted through the peripheral portion (24) and into the threads (46) established under the flat face of the flange and said one of the case portions.

8. Electrical device according to claim 7, **characterised in that** the support comprises metal sleeves (25) wherein the screws are inserted, with screw heads pressing on the sleeves.

9. Electrical device according to claim 1, **characterised in that** it comprises another seal (40), compressed between the peripheral portion and one of the flat faces of the flanges.
